(19) Europäisches Patentamt / European Patent Office / Office européen des brevets

(11) **EP 4 163 720 A1**

(12) **EUROPEAN PATENT APPLICATION**
published in accordance with Art. 153(4) EPC

(43) Date of publication:
**12.04.2023 Bulletin 2023/15**

(21) Application number: **21820863.5**

(22) Date of filing: **27.05.2021**

(51) International Patent Classification (IPC):
**G03F 1/64** *(2012.01)*

(52) Cooperative Patent Classification (CPC):
**G03F 1/64**

(86) International application number:
**PCT/JP2021/020161**

(87) International publication number:
**WO 2021/251157 (16.12.2021 Gazette 2021/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.06.2020 JP 2020099139**

(71) Applicant: **SHIN-ETSU CHEMICAL CO., LTD.**
**Tokyo 1000005 (JP)**

(72) Inventor: **YANASE, Yu**
**Annaka-shi, Gunma 379-0127 (JP)**

(74) Representative: **Held, Stephan**
**Meissner Bolte Patentanwälte**
**Rechtsanwälte Partnerschaft mbB**
**Widenmayerstraße 47**
**80538 München (DE)**

(54) **PELLICLE FRAME, PELLICLE, EXPOSURE ORIGINAL PLATE WITH PELLICLE, EXPOSURE METHOD, METHOD FOR MANUFACTURING SEMICONDUCTOR, AND METHOD FOR MANUFACTURING LIQUID CRYSTAL DISPLAY BOARD**

(57) Provided are a pellicle frame (1), a pellicle, an exposure original plate with a pellicle, an exposure method, a method for manufacturing a semiconductor, and a method for manufacturing a liquid crystal display board, the frame-shaped pellicle frame (1) having an upper end surface (13) on which a pellicle film is provided, and a lower end surface (14) facing a photomask, wherein the pellicle frame (1) is metallic, a cutout portion (20) with the upper end surface (13) or the lower end surface (14) opened is provided from the outer surface toward the inner surface thereof, and the total ventilation area in the inner surface is 0.001 mm$^2$ or more per 1 mm$^3$ of the volume of an inner space of the pellicle. It becomes thus possible to provide a pellicle frame wherein a pellicle film is not broken by withstanding a pressure change from atmospheric pressure to vacuum when EUV exposure is performed under vacuum, frame workability is good, and a frame is not broken when a pellicle is peeled off.

FIG.1A

EP 4 163 720 A1

# FIG.1B

# FIG.1C

**Description**

TECHNICAL FIELD

This invention relates to a pellicle which is mounted on a lithographic photomask as a dust cover, pellicle frame, pellicle-mounted exposure original, exposure method, method for manufacturing semiconductor device, and method for manufacturing liquid crystal (LC) display panel.

BACKGROUND ART

In recent years, the miniaturization of the design rule of LSIs is in progress to the sub-quarter-micron order. Concomitantly, the exposure light source becomes shorter in wavelength. Specifically, the exposure light source makes a transition from g-line (436 nm) and i-line (365 nm) of mercury lamps to KrF excimer laser (248 nm) and ArF excimer laser (193 nm). A further study is made on the EUV lithography using extreme ultraviolet (EUV) radiation of main wavelength 13.5 nm.

In the manufacture of semiconductor devices such as LSIs and VLSIs or LC display panels, semiconductor wafers or LC matrices are exposed to light to print patterns. If dust is deposited on lithographic photomasks and reticles (collectively referred to as "exposure original," hereinafter) used herein, the dust absorbs or deflects light, raising such problems that the transferred pattern can be deformed or roughened at the edge, and the background be stained black, detracting from size, quality, appearance and other factors.

Although these operations are generally performed in a cleanroom, it is yet difficult to always maintain the exposure original clean. It is thus a common practice to attach a pellicle to the surface of the exposure original as a dust cover before exposure. In this situation, contaminants do not directly deposit on the surface of the exposure original, but on the pellicle. Now that a focus is set on the pattern of the exposure original during lithographic transfer, the contaminants on the pellicle do not participate in the transfer.

The pellicle is basically constructed such that a pellicle membrane having a high transmittance to radiation used in the exposure is extended on the upper end surface of a pellicle frame made of aluminum or titanium, and a gas-tight gasket is formed on the lower end surface of the pellicle frame. A pressure-sensitive adhesive (PSA) layer is generally used as the gas-tight gasket. A protective sheet is attached to the PSA layer for protection purpose. While the pellicle membrane is made of nitrocellulose, cellulose acetate, and fluoro-polymers which are fully transmissive to radiation used in the exposure such as g-line (436 nm) or i-line (365 nm) of mercury lamps, KrF excimer laser (248 nm) or ArF excimer laser (193 nm), a very thin silicon membrane or carbon membrane is investigated as the pellicle membrane for the EUV lithography.

In particular, since the EUV lithography is performed under vacuum, the pellicle for EUV lithography must be resistant to pressure changes from atmospheric to vacuum. The EUV pellicle is thus required to have a relatively large ventilating area.

Patent Document 1 discloses a pellicle comprising a pellicle frame having two opposed side surfaces wherein each side surface is provided with a ventilating port having an opening area on one side surface which is 50 to 90% of the area on the other side surface. However, since the ventilating area relative to the volume of the inner space of the pellicle affects pressure changes across the pellicle, it is still insufficient to take into account only the percent opening area of the pellicle frame.

Patent Document 2 discloses a pellicle frame of ceramic material which is provided with through-holes wherein the total of flowpath areas of the through-holes is at least 0.005 cm$^2$ per cm$^3$ of the volume of the inner space of a pellicle. However, the ceramic material is not ductile. When strong forces are locally applied to the pellicle frame as in dismounting of the pellicle, the pellicle frame can be broken to release contaminants. One common approach for imparting strength to the pellicle frame is to make the pellicle frame thicker. Since the pellicle for EUV lithography is limited to the maximum height of 2.5 mm, the approach of making the pellicle frame thicker to prevent breakage is less viable.

PRIOR ART DOCUMENTS

PATENT DOCUMENTS

Patent Document 1: JP-A 2004-294786

Patent Document 2: JP-A 2018-200380

## SUMMARY OF INVENTION

## TECHNICAL PROBLEM

An object of the invention, which has been made under the above-mentioned circumstances, is to provide a pellicle comprising a pellicle frame which withstands pressure changes from atmospheric to vacuum to mitigate the risk of rupturing the pellicle membrane when EUV lithography is performed in vacuum, is effectively workable, and is less prone to breakage in dismounting of the pellicle.

## SOLUTION TO PROBLEM

The inventor has reached a pellicle frame in a frame shape having an upper end surface adapted to bear a pellicle membrane to construct a pellicle, a lower end surface adapted to face a photomask, an inside surface, and an outside surface, wherein the pellicle frame is provided at one end surface with notches which extend from the outside surface to the inside surface, each notch defines a ventilating area at the inside surface, outside surface, pellicle inner space side or pellicle outer space side, and the total of the ventilating areas is at least 0.001 mm$^2$ per mm$^3$ of the volume of the pellicle inner space. This pellicle frame can mitigate the risk of the pellicle membrane being ruptured by pressure changes. Although the pellicle frame must be precisely machined in order to provide the pellicle frame with a plurality of ventilating ports, the use of a ductile metal material is effective for mitigating the loss by breakage of the pellicle frame during machining and reducing the risk of breaking the pellicle frame in dismounting of the pellicle from the photomask. The invention is predicated on this finding.

Accordingly, the invention provides a pellicle frame, pellicle, pellicle-mounted exposure original, exposure method, method for manufacturing semiconductor device, and method for manufacturing LC display panel, as defined below.

1. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area at the inside surface, and the total of the ventilating areas is at least 0.001 mm$^2$ per mm$^3$ of the inner space of the pellicle.

2. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area on the inner space side of the pellicle, and the total of the ventilating areas is at least 0.001 mm$^2$ per mm$^3$ of the inner space of the pellicle.

3. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area at the outside surface, and the total of the ventilating areas is at least 0.001 mm$^2$ per mm$^3$ of the inner space of the pellicle.

4. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area on the outer space side of the pellicle, and the total of the ventilating areas is at least 0.001 mm$^2$ per mm$^3$ of the inner space of the pellicle.

5. The pellicle frame of any one of 1 to 4 which is provided with a through-hole having an opening at least on the inside surface.

6. The pellicle frame of any one of 1 to 4 wherein the metal material of the pellicle frame is selected from the group consisting of titanium, a titanium alloy, aluminum, and an aluminum alloy.

7. The pellicle frame of any one of 1 to 4 wherein the total of the ventilating areas is up to 0.02 mm$^2$ per mm$^3$ of the inner space of the pellicle.

8. The pellicle frame of any one of 1 to 4 wherein the notch has a height which is up to 50% of the thickness of the pellicle frame.

9. The pellicle frame of any one of 1 to 4 wherein the pellicle frame has a thickness of up to 2.5 mm.

10. A pellicle comprising the pellicle frame of any one of 1 to 9 and a pellicle membrane which is disposed on the upper end surface of the pellicle frame via a pressure-sensitive adhesive or adhesive.

11. The pellicle of 10 which is used in exposure under vacuum or reduced pressure.

12. The pellicle of 10 or 11 which is used in EUV lithography.

13. The pellicle of 10 or 11, having a height of up to 2.5 mm.

14. The pellicle of 10 or 11 wherein the pellicle membrane is a pellicle membrane held by a rim.

15. A pellicle-mounted exposure original comprising an exposure original and the pellicle of 10 mounted thereon.

16. The pellicle-mounted exposure original of 15 wherein the exposure original is an exposure original for EUV lithography.

17. The pellicle-mounted exposure original of 15 which is a pellicle-mounted exposure original for use in EUV lithography.

18. An exposure method comprising the step of exposure through the pellicle-mounted exposure original of 15.

19. A method for manufacturing a semiconductor device comprising the step of exposing a substrate to radiation through the pellicle-mounted exposure original of 15 under vacuum or reduced pressure.

20. A method for manufacturing a liquid crystal display panel comprising the step of exposing a substrate to radiation through the pellicle-mounted exposure original of 15 under vacuum or reduced pressure.

21. A method for manufacturing a semiconductor device comprising the step of exposing a substrate to EUV through the pellicle-mounted exposure original of 15.

22. A method for manufacturing a liquid crystal display panel comprising the step of exposing a substrate to EUV through the pellicle-mounted exposure original of 15.

## ADVANTAGEOUS EFFECTS OF INVENTION

A pellicle frame and a pellicle according to the invention mitigate the risk of the pellicle membrane being ruptured by pressure changes from atmospheric to vacuum and substantially avoid the breakage of the pellicle frame during machining of the frame and dismounting of the pellicle. The invention is particularly useful in pellicles for the EUV lithography. The pellicle is useful in a semiconductor device or LC display panel manufacturing method involving the step of exposing a substrate to radiation through a pellicle-mounted exposure original.

## BRIEF DESCRIPTION OF DRAWINGS

[FIG. 1] FIG. 1 schematically illustrates a pellicle frame according to one embodiment of the invention, FIG. 1(A) being as viewed from the side of upper end surface, FIG. 1(B) being as viewed from the side of long outside surface, and FIG. 1(C) being as viewed from the side of short outside surface.

[FIG. 2] FIG. 2 is a schematic view of the inventive pellicle mounted on a photomask.

[FIG. 3] FIG. 3 schematically illustrates a pellicle frame according to another embodiment of the invention, FIG. 3(A) being as viewed from the side of upper end surface,

FIG. 3(B) being as viewed from the side of long outside surface, and FIG. 3(C) being as viewed from the side of short outside surface.

## DESCRIPTION OF EMBODIMENTS

Now the invention is described in detail.

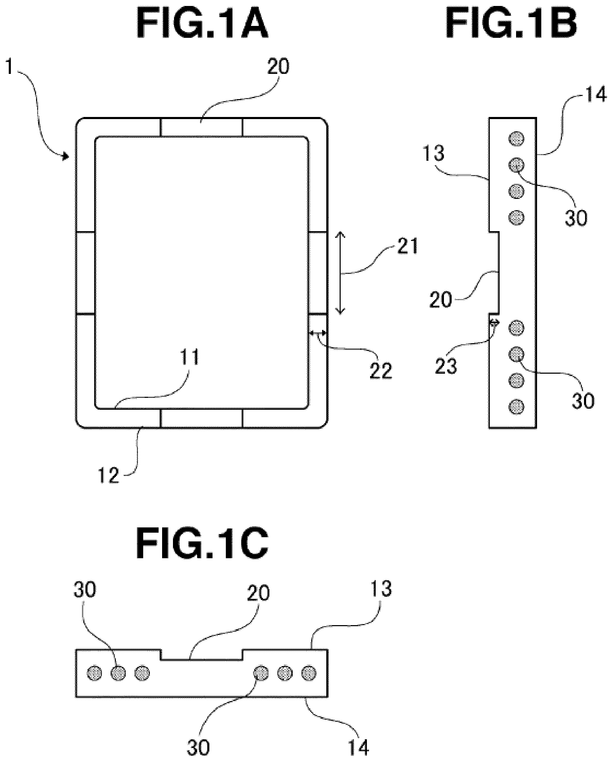

FIGS. 1(A) to 1(C) illustrate a pellicle frame 1 according to one embodiment of the invention. The pellicle frame 1 has an inside surface 11, an outside surface 12, an upper end surface 13, and a lower end surface 14. The pellicle frame 1 is provided on its upper end surface with notches 20. Each notch 20 has a width 21, a depth 22, and a height 23. The pellicle frame 1 is also provided with a plurality of through-holes 30. Though not shown in FIG. 1, the pellicle frame 1 is typically provided on its long side with a jig hole which is utilized during dismounting of the pellicle from the photomask.

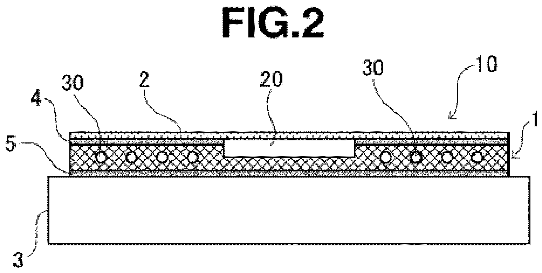

FIG. 2 illustrates a pellicle-mounted photomask 10, that is, a pellicle is mounted on a photomask 3. A pellicle membrane 2 is attached or bonded to the upper end surface of the pellicle frame 1 via a PSA or adhesive 4. Also, the lower end surface of the pellicle frame 1 is releasably attached or bonded to the photomask 3 via a PSA or adhesive 5, for protecting the patterned surface of the photomask 3.

As shown in FIG. 1, the invention provides a pellicle frame in a frame shape having an upper end surface adapted to bear a pellicle membrane and a lower end surface adapted to face a photomask.

As long as the pellicle frame is in a frame shape, its shape corresponds to the shape of a photomask on which a pellicle is mounted. In general, it is a four-sided (rectangular or square) frame. The shape of corners or edges of the pellicle frame may be an angular or pointed shape as primarily machined or another shape, typically curvilinear shape as homed or chamfered such as by rounding or chamfering.

The pellicle frame further has a surface (referred to as upper end surface) on which a pellicle membrane is to be extended and a surface (referred to as lower end surface) adapted to face a photomask when the pellicle is mounted on the photomask.

As shown in FIG. 2, the pellicle frame is provided on its upper end surface with a pellicle membrane via an adhesive and on its lower end surface with a PSA layer for mounting the pellicle on the photomask although the invention is not limited thereto.

The material of which the pellicle frame is made is preferably a ductile metal material. Since the EUV lithography requires a higher accuracy than the ArF lithography, a severe requirement of flatness is imposed on the photomask. It is known that a pellicle has an impact on the flatness of a photomask. To minimize the impact of pellicle on photomask, lightweight metals such as titanium, titanium alloys, aluminum, and aluminum alloys are preferably used.

The size of the pellicle frame is not particularly limited. Since the height of the pellicle for the EUV lithography is limited to 2.5 mm or less, the thickness of the pellicle frame for the EUV lithography is preferably smaller than the height, i.e., 2.5 mm or less. The thickness of the pellicle frame for the EUV lithography is more preferably equal to or less than 1.5 mm when the thicknesses of a pellicle membrane and photomask PSA are taken into account. The lower limit of thickness of the pellicle frame is preferably 1.0 mm or more.

The pellicle frame is provided with notches which are open at the upper end surface or the lower end surface and extend from the outside surface to the inside surface. That is, the notch refers to a recess or depression which is cut in the upper or lower end surface of the pellicle frame and extends from the outside surface to the inside surface. As shown in FIGS. 1(B) and 1(C), for example, the notch 20 is a recess having a substantially U shape as viewed from the outside of the pellicle frame. The recess of substantially U shape encompasses a rectangular shape with an angular corner and a rectangular shape with a rounded corner. Also as shown in FIG. 1(A), the notch 20 is formed as a channel having an equal width from the outside surface to the inside surface, as viewed from the top, but not limited thereto, for example, as a channel of tapered shape which diverges or converges gradually from the outside surface to the inside surface. Further, the height (depicted at 23 in FIG. 1) of the notch is not limited to equality, but may be of tapered shape which expands or contracts gradually from the outside surface to the inside surface. The location and number of notches are not particularly limited.

The shape and size of a notch are not particularly limited. When the height (depicted at 23 in FIG. 1) of the notch is increased, the thickness of the portion of the pellicle frame underlying the notch is accordingly reduced, with a possibility that upon dismounting of the pellicle, the pellicle frame is folded at the thinnest portion as a starting point and the pellicle membrane is ruptured by that impact. The rupture of the pellicle membrane upon dismounting of the pellicle is a problem because it takes a time until the photomask is recovered. Therefore, the height of the notch is preferably up to 50%, more preferably up to 30%, even more preferably up to 15% of the thickness of the pellicle frame. On the other hand, the height of the notch is preferably at least 5% of the thickness of the pellicle frame, as viewed from ease of machining.

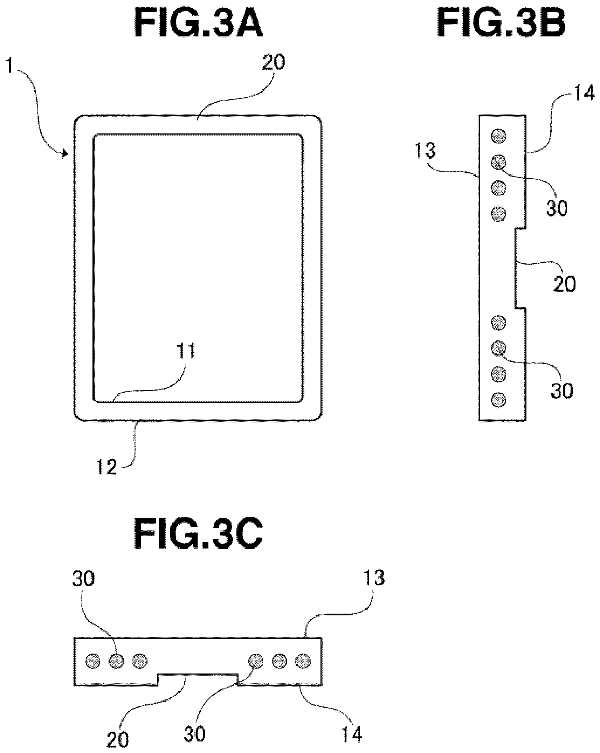

Notably, in the embodiment of FIG. 1, the pellicle frame 1 is provided on its upper end surface with the notches 20. FIGS. 3(A) to 3(C) show another embodiment wherein the pellicle frame 1 is provided on its lower end surface with the notches 20.

For the purpose of preventing the pellicle membrane from rupture against pressure changes from atmospheric pressure to vacuum, the setting that the total of ventilating areas is at least 0.001 mm$^2$ per mm$^3$ of the volume of the pellicle inner space is necessary, provided that each notch defines a ventilating area at the inside surface, outside surface, pellicle inner space side or pellicle outer space side. A larger ventilating area is preferable for reducing the risk of the pellicle membrane being ruptured. The total of ventilating areas is preferably at least 0.0013 mm$^2$, more preferably at least 0.0015 mm$^2$ per mm$^3$ of the volume of the pellicle inner space. The upper limit is preferably up to 0.02 mm$^2$, more preferably up to 0.015 mm$^2$, from the standpoints of preventing the breakage and maintaining the strength of the pellicle frame.

Also preferably, the pellicle frame is provided with a through-hole having an opening at least on the inside surface. That is, one opening of the through-hole is formed on the inside surface of the pellicle frame and the other opening of the through-hole is formed on the outside surface of the pellicle frame or the upper end surface of the pellicle frame where the pellicle membrane is rested. In the embodiment wherein the other opening of the through-hole is formed on the upper end surface of the pellicle frame, a filter may be attached to the upper end surface, which is advantageous in the case of a thin pellicle frame for EUV lithography.

Although the shape and size of the through-hole or ventilating port are not particularly limited, the shape is preferably circular or elliptic and the opening area is preferably at least 0.03 mm$^2$. Also for ease of machining, the thinnest portion between the pellicle end surface and the ventilating port is preferably at least 0.2 mm.

Although the pellicle frame of FIG. 1 is provided with both the notches and the through-holes or ventilating ports, the invention is not limited thereto. It is acceptable that only the notches are formed. Preferably, the ventilating portion is given a certain area so as to exert the desired effect, and the notches and the through-holes are used in combination in order to provide the pellicle frame with a sufficient strength, as will be described later. In this case, on each of the long and short sides of the pellicle frame, the area of notches is 0.05 to 400 mm$^2$ and the number of notches is in the range of 1 to 50, whereas the area of through-holes is 0.03 to 130 mm$^2$ and the number of through-holes is in the range of 1 to 250.

Provided that a pellicle is completed from the pellicle frame of the invention, each notch defines a ventilating area at the inside surface, outside surface, pellicle inner space side or pellicle outer space side. In one example wherein the pellicle frame is provided with 40 ventilating ports having a diameter of 0.8 mm, 40 notches having a width (depicted at 21 in FIG. 1) of 10 mm and a height (depicted at 23 in FIG. 1) of 0.2 mm are formed in the end surface of the pellicle frame facing the pellicle membrane, and a PSA layer for pellicle membrane having a thickness of 0.1 mm is formed on the upper end surface of the pellicle frame excluding the notches, the total of ventilating areas available in the pellicle is 140 mm$^2$. That is, the thickness of the PSA layer is calculated as being included in the ventilating area.

$$\text{[area of ventilating ports: formula 1]} \quad 0.4 \times 0.4 \times 3.14 \times 40 \text{ (number)} = 20.096 \text{ (mm}^2\text{)}$$

$$\text{[opening area of notches: formula 2]} \quad 10 \times (0.2 + 0.1) \times 40 \text{ (number)} = 120 \text{ (mm}^2\text{)}$$

That is, in the embodiment wherein the pellicle frame is provided with notches, the notches are easier to machine than the ventilating ports, and the thickness of the overlying PSA layer is additively included in the ventilating space other than the notches as mentioned just above. It is greatly advantageous to essentially include notches as ventilating portion according to the invention.

As used herein, the volume of the inner space of the pellicle refers to the volume of true inner space including the thickness of PSA layer when the pellicle is completed. In one example wherein the pellicle frame has internal dimensions: length 143 mm by width 110 mm by height 1.5 mm, the pellicle membrane PSA layer and photomask PSA layer each have a thickness of 0.1 mm, the pellicle membrane is a very thin single-crystal silicon membrane held by a Si rim having a height of 0.725 mm, the volume of the pellicle inner space is 38,145 mm$^3$ because the very thin silicon membrane is thin enough to neglect upon volume calculation.

$$\text{[volume of pellicle inner space: formula 3]}$$

$$143 \times 110 \times (1.5 + 0.1 + 0.1 + 0.725) = 38145.25 \text{ (mm}^3\text{)}$$

Then the total of ventilating areas is (20.096 mm$^2$ + 120 mm$^2$)/38145 mm$^3$ $\cong$ 0.0037, that is, ~0.0037 mm$^2$ per mm$^3$ of the pellicle inner space volume.

The ventilating portion may be provided with a filter, if necessary.

The pellicle of the invention includes the pellicle frame as defined above and a pellicle membrane disposed on the upper end surface thereof via a PSA or adhesive for pellicle membrane. While the material of the PSA or adhesive for pellicle membrane is not particularly limited, any well-known ones may be used. A PSA or adhesive is generally formed on one end surface of the pellicle frame over its entire periphery to a width which is equal to or less than the width of the pellicle frame. Where a notch is provided on one end surface of the pellicle frame, the PSA or adhesive is preferably formed on the end surface excluding the notch.

Although the material of the pellicle membrane is not particularly limited, a material having a high transmittance at the wavelength of the exposure light source and high light resistance is preferred. For example, a very thin silicon membrane, silicon membrane, carbon membrane (e.g., graphene, diamond-like carbon, and carbon nanotubes) or the like is used in the EUV lithography. When it is difficult to handle a pellicle membrane alone, a pellicle membrane supported by a rim of silicon or the like may be used. In this case, a pellicle can be readily constructed by bonding the region of the rim to the pellicle frame.

Further, the pellicle frame is provided on its lower end surface with a PSA or adhesive for mounting the pellicle on the photomask. In general, the PSA or adhesive is preferably formed on one end surface of the pellicle frame over its entire periphery to a width which is equal to or less than the width of the pellicle frame. Where a notch is provided on one end surface of the pellicle frame, the PSA or adhesive is formed on the end surface excluding the notch.

As the photomask PSA, any of well-known agents may be used, for example, acrylic PSA, silicone base PSA, and rubber base PSA. Inter alia, the silicone base PSA is preferred from the aspect of heat resistance. The PSA may have been worked to any desired shape, if necessary.

To the lower end surface of the photomask PSA, a release layer or separator may be attached for protecting the PSA. While the material of the release layer is not particularly limited, use may be made of polyethylene terephthalate (PET), polytetrafluoroethylene (PTFE), tetrafluoroethylene-perfluoroalkyl vinyl ether copolymers (PFA), polyethylene (PE), polycarbonate (PC), polyvinyl chloride (PVC), and polypropylene (PP), for example. Also, if necessary, such release agents as silicone-based release agents and fluorochemical release agents may be coated on the surface of the release layer.

The pellicle frame may be provided with an outward or inward projection. When such a projection is used, the filter may be formed in the projection. When the outward projection is provided with a connection means (e.g., screw or PSA) to an exposure original, the PSA for the photomask may be omitted.

The pellicle of the invention may serve not only as a protective member for protecting an exposure original from particulate contamination in an EUV aligner, but also as a protective member for protecting an exposure original during its storage or transportation. In preparing a pellicle-mounted exposure original by mounting a pellicle on an exposure original, typically photomask, an electrostatic chucking method, mechanical securing method or the like may be used as well as the aforementioned method of bonding with the photomask PSA.

A further embodiment of the invention is a method for manufacturing a semiconductor device or LC display panel, which includes the step of exposing a substrate (semiconductor wafer or LC matrix) to radiation through the pellicle-mounted exposure original. For example, in the lithography step which is one of the steps of the process of manufacturing a semiconductor device or LC display panel, the stepper is installed with the pellicle-mounted exposure original and exposure is performed to form a photoresist pattern corresponding to an integrated circuit or the like on a substrate. In general, a projection optical system is used in the EUV lithography such that EUV radiation is reflected by the exposure original and directed to the substrate. The exposure step is performed under reduced pressure or vacuum. Even when contaminants deposit on the pellicle in the lithography step, the contaminants are out of focus on the photoresist-coated wafer, preventing the images of contaminants from causing short- or open-circuiting in the integrated circuit. Therefore, the yield of the lithography step can be improved by using the pellicle-mounted exposure original.

EXAMPLES

Examples and Comparative Examples are given below for illustrating the invention, but the invention is not limited thereto.

[Example 1]

There was furnished a pellicle frame (inner dimensions 143 mm by 110 mm by height 1.5 mm, width 4 mm) of titanium. The pellicle frame was provided in the upper end surface at the center of each side with a notch of width 30 mm by height 0.1 mm by depth 4 mm. The pellicle frame was also provided on each side with 12 through-holes of diameter 0.8 mm.

The pellicle frame was cleaned, after which a material obtained by adding 1 part by weight of curing agent (PT-56 by Shin-Etsu Chemical Co., Ltd.) to 100 parts by weight of silicone base PSA (X-40-3264 by Shin-Etsu Chemical Co., Ltd.) and stirring was coated onto the upper end surface of the pellicle frame, excluding the notches, to form a PSA layer of 1 mm wide and 0.1 mm thick. A photomask PSA obtained by adding 0.1 part by weight of curing agent (L-45 by Soken Chemical & Engineering Co., Ltd.) to 100 parts by weight of acrylic PSA (SK-Dyne 1499M by Soken Chemical & Engineering Co., Ltd.) and stirring was coated onto the lower end surface of the pellicle frame to form a layer of 1 mm wide and 0.1 mm thick along the overall periphery. Thereafter, the pellicle frame was heated at 100°C for 12 hours to cure the PSA layers on the upper and lower end surfaces. Subsequently, a very thin silicon membrane of 50 nm thick held by a silicon rim of 0.725 mm thick as the pellicle membrane was compression bonded to the PSA layer on the upper end surface of the pellicle frame to complete a pellicle.

[Example 2]

There was furnished a pellicle frame (inner dimensions 143 mm by 110 mm by height 1.5 mm, width 4 mm) of aluminum. The pellicle frame was provided on each side with 48 through-holes of diameter 0.8 mm. Except the shape of the frame, Example 2 is the same as Example 1.

[Comparative Example 1]

There was furnished a pellicle frame (inner dimensions 143 mm by 110 mm by height 1.5 mm, width 4 mm) of titanium. The pellicle frame was provided in the upper end surface at the center of each side with a notch of width 30 mm by height 0.1 mm by depth 4 mm. Except the shape of the frame, Comparative Example 1 is the same as Example 1.

[Comparative Example 2]

Using a ceramic material or alumina, an attempt was made to prepare a pellicle frame of Example 1. The frame was broken in the course of preparation.

[Vacuum test]

The pellicles prepared in Examples 1 and 2 and Comparative Example 1 were mounted on quartz masks of 6 inches square, and subjected to a vacuum test. The vacuum test involved the steps of placing the pellicle-mounted mask in a vacuum chamber, vacuum pumping the chamber from atmospheric to 1 Pa within 170 seconds, and restoring from 1 Pa to atmospheric pressure within 250 seconds. It was observed whether or not the pellicle membrane was ruptured, with the results shown in Table 1.

[Table 1]

| | Workability | Ventilating area ($mm^2$) | Inner space ($mm^3$) | Area/volume ($mm^2/mm^3$) | Vacuum test |
|---|---|---|---|---|---|
| Example 1 | ○ | 48 | 38145 | 0.0013 | ○ |
| Example 2 | ○ | 96 | 38145 | 0.0025 | ○ |
| Comparative Example 1 | ○ | 24 | 38145 | 0.0006 | × (membrane rupture) |
| Comparative Example 2 | × (broken) | - | - | - | - |

As is evident from the results in Table 1, Examples 1 and 2 are satisfactory because no rupture of the pellicle membrane was observed, whereas a rupture of the pellicle membrane was observed in Comparative Example 1.

REFERENCE SIGNS LIST

1    pellicle frame
11   inside surface of pellicle frame
12   outside surface of pellicle frame
13   upper end surface of pellicle frame
14   lower end surface of pellicle frame
20   notch
21   width of notch
22   depth of notch
23   height of notch
30   throughhole (ventilating port)
2    pellicle membrane
3    photomask
4    PSA or adhesive for pellicle membrane
5    PSA or adhesive for photomask
10   pellicle-mounted photomask

**Claims**

1.  A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area at the inside surface, and the total of the ventilating areas is at least 0.001 $mm^2$ per $mm^3$ of the inner space of the pellicle.

2. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area on the inner space side of the pellicle, and the total of the ventilating areas is at least 0.001 $mm^2$ per $mm^3$ of the inner space of the pellicle.

3. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area at the outside surface, and the total of the ventilating areas is at least 0.001 $mm^2$ per $mm^3$ of the inner space of the pellicle.

4. A pellicle frame in a frame shape having an upper end surface adapted to bear a pellicle membrane to construct a pellicle, a lower end surface adapted to face a photomask, an inside surface, and an outside surface, wherein the pellicle frame is made of a metal material and provided with notches which are open at the upper end surface or the lower end surface and extend from the outside surface to the inside surface, each notch defines a ventilating area on the outer space side of the pellicle, and the total of the ventilating areas is at least 0.001 $mm^2$ per $mm^3$ of the inner space of the pellicle.

5. The pellicle frame of any one of claims 1 to 4 which is provided with a through-hole having an opening at least on the inside surface.

6. The pellicle frame of any one of claims 1 to 4 wherein the metal material of the pellicle frame is selected from the group consisting of titanium, a titanium alloy, aluminum, and an aluminum alloy.

7. The pellicle frame of any one of claims 1 to 4 wherein the total of the ventilating areas is up to 0.02 $mm^2$ per $mm^3$ of the inner space of the pellicle.

8. The pellicle frame of any one of claims 1 to 4 wherein the notch has a height which is up to 50% of the thickness of the pellicle frame.

9. The pellicle frame of any one of claims 1 to 4 wherein the pellicle frame has a thickness of up to 2.5 mm.

10. A pellicle comprising the pellicle frame of any one of claims 1 to 9 and a pellicle membrane which is disposed on the upper end surface of the pellicle frame via a pressure-sensitive adhesive or adhesive.

11. The pellicle of claim 10 which is used in exposure under vacuum or reduced pressure.

12. The pellicle of claim 10 or 11 which is used in EUV lithography.

13. The pellicle of claim 10 or 11, having a height of up to 2.5 mm.

14. The pellicle of claim 10 or 11 wherein the pellicle membrane is a pellicle membrane held by a rim.

15. A pellicle-mounted exposure original comprising an exposure original and the pellicle of claim 10 mounted thereon.

16. The pellicle-mounted exposure original of claim 15 wherein the exposure original is an exposure original for EUV lithography.

17. The pellicle-mounted exposure original of claim 15 which is a pellicle-mounted exposure original for use in EUV lithography.

18. An exposure method comprising the step of exposure through the pellicle-mounted exposure original of claim 15.

19. A method for manufacturing a semiconductor device comprising the step of exposing a substrate to radiation through the pellicle-mounted exposure original of claim 15 under vacuum or reduced pressure.

20. A method for manufacturing a liquid crystal display panel comprising the step of exposing a substrate to radiation through the pellicle-mounted exposure original of claim 15 under vacuum or reduced pressure.

21. A method for manufacturing a semiconductor device comprising the step of exposing a substrate to EUV through the pellicle-mounted exposure original of claim 15.

22. A method for manufacturing a liquid crystal display panel comprising the step of exposing a substrate to EUV through the pellicle-mounted exposure original of claim 15.

# FIG.1A

# FIG.1B

# FIG.1C

# FIG.2

# FIG.3A

# FIG.3B

# FIG.3C

<table>
<tr><td colspan="2" align="center"><b>INTERNATIONAL SEARCH REPORT</b></td><td colspan="2">International application No.<br>PCT/JP2021/020161</td></tr>
</table>

A.   CLASSIFICATION OF SUBJECT MATTER
G03F 1/64(2012.01)i
FI: G03F1/64

According to International Patent Classification (IPC) or to both national classification and IPC

B.   FIELDS SEARCHED

Minimum documentation searched (classification system followed by classification symbols)
G03F1/64

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2020-42105 A (NGK SPARK PLUG CO., LTD.) 19 March 2020 (2020-03-19) paragraphs [0012], [0045]-[0046], [0051]-[0056], [0068], fig. 1-3 | 1-22 |
| Y | JP 2019-70745 A (SHIN-ETSU CHEMICAL CO., LTD.) 09 May 2019 (2019-05-09) paragraph [0040] | 1-22 |
| Y | JP 2004-191986 A (ASML HOLDING, N.V.) 08 July 2004 (2004-07-08) paragraph [0051] | 1-22 |
| Y | JP 2010-107986 A (MST TECHNOLOGY CO., LTD.) 13 May 2010 (2010-05-13) paragraph [0008] | 1-22 |
| Y | US 2006/0246234 A1 (YAZAKI CORPORATION) 02 November 2006 (2006-11-02) paragraph [0022] | 1-22 |

☐   Further documents are listed in the continuation of Box C.        ☒   See patent family annex.

| | |
|---|---|
| \*        Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 03 August 2021 (03.08.2021) | 10 August 2021 (10.08.2021) |

| Name and mailing address of the ISA/<br>Japan Patent Office<br>3-4-3, Kasumigaseki, Chiyoda-ku,<br>Tokyo 100-8915, Japan | Authorized officer<br><br><br>Telephone No. |
|---|---|

Form PCT/ISA/210 (second sheet) (January 2015)

**INTERNATIONAL SEARCH REPORT**
Information on patent family members

International application No.

PCT/JP2021/020161

| Patent Documents referred in the Report | Publication Date | Patent Family | Publication Date |
|---|---|---|---|
| JP 2020-42105 A | 19 Mar. 2020 | (Family: none) | |
| JP 2019-70745 A | 09 May 2019 | US 2019/0107774 A1 paragraph [0045] EP 3470921 A1 CN 109656095 A KR 10-2019-0040445 A TW 201928077 A | |
| JP 2004-191986 A | 08 Jul. 2004 | US 2003/0123042 A1 paragraph [0057] US 2005/0088637 A1 US 2007/0127000 A1 WO 2001/059522 A1 KR 10-2004-0050856 A CN 1506764 A TW 200416481 A | |
| JP 2010-107986 A | 13 May 2010 | KR 10-2010-0049445 A | |
| US 2006/0246234 A1 | 02 Nov. 2006 | WO 2006/113859 A2 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004294786 A
- JP 2018200380 A